Europäisches Patentamt

European Patent Office

Office européen des brevets

(11) Publication number: **0 057 329**
**B1**

# EUROPEAN PATENT SPECIFICATION

(45) Date of publication of patent specification: **30.04.86**

(21) Application number: **81306068.8**

(22) Date of filing: **23.12.81**

(51) Int. Cl.⁴: **H 05 K 7/14,** G 11 C 19/08,
H 01 R 13/631

(54) **Electrical connecting arrangement.**

(30) Priority: **29.12.80 JP 187224/80**

(43) Date of publication of application:
**11.08.82 Bulletin 82/32**

(45) Publication of the grant of the patent:
**30.04.86 Bulletin 86/18**

(84) Designated Contracting States:
**DE FR GB**

(56) References cited:
**GB-A-1 119 619**
**US-A-3 575 482**
**US-A-4 236 190**

(73) Proprietor: **FUJITSU LIMITED**
**1015, Kamikodanaka Nakahara-ku**
**Kawasaki-shi Kanagawa 211 (JP)**

(72) Inventor: **Sakai, Hirohumi**
**2528-1, Hongo-cho Suzaka-shi**
**Nagano 382 (JP)**
Inventor: **Sukeda, Toshiaki**
**406-3, Sakata-cho Suzaka-shi**
**Nagano 382 (JP)**
Inventor: **Yodoshi, Hiroyuki**
**1593-29-2, Hachiman-cho Suzaka-shi**
**Nagano 382 (JP)**
Inventor: **Imai, Satoru**
**1424-A1-404, Oaza Yanagihara Nagano-shi**
**Nagano, 380 (JP)**

(74) Representative: **Sunderland, James Harry et al**
**HASELTINE LAKE & CO Hazlitt House**
**28 Southampton Buildings Chancery Lane**
**London WC2A 1AT (GB)**

Courier Press, Leamington Spa, England.

## Description

The present invention relates to an electrical connecting arrangement having at least two connector units, electrical terminals of which connector units are connected by inserting one connector unit into the other.

For electrical connection, a plug terminal is usually provided for one connector unit and a jack terminal provided for the other connector unit. The units are coupled and electrical connection established by inserting the plug terminal into the jack terminal.

Such a plug and jack connecting structure offers a reliability superior to that of an electrical connecting structure of the pressure contact type. However, such a connecting structure has a disadvantage in that as the numbers of plug and jack terminals increase, insertion force and withdrawal force become larger. In addition, since insertion force gradually increases as insertion proceeds, an operator may feel somewhat uneasy about establishing connection; that is, an operator cannot sense how far a unit must be inserted to establish perfect electrical connection. An operator who is uneasy in this way may effect an insertion operation using excessive insertion force and thereby terminals are at risk of being broken.

US—A—4 236 190 discloses an electrical connecting arrangement, for instance for a 'racking' system in which modular electronic equipment is supported by a rack. In the arrangement electrical terminals of male and female mating shells are connected by inserting the female shell onto the male shell, or vice versa. Within the female shell is a rotatable member providing a coupling part for engagement with the male shell, which member is arranged to be rotated by the insertion movement of the male shell into the female shell, the rotation of the rotatable member causing the coupling part to engage with a slot in the male shell.

GB—A—1 119 619 discloses the use of bistable biasing springs in plugboard apparatus having a plugboard movable in relation to a rear board.

According to the present invention there is provided an electrical connecting arrangement, comprising first and second connector units, electrical terminals of which are connected by inserting the first connector unit into the second connector unit, and a rotatable member within the second connector unit, providing a coupling part for engagement with the first connector unit, the rotatable member being arranged to be rotated by the insertion movement of the first connector unit into the second connector unit, the rotation of said rotatable member causing the coupling part to engage with a recess in the first connector unit, characterised in that spring means are provided to urge the first connector unit in the direction of insertion via said engagement.

An embodiment of the present invention can provide a connecting structure which can ensure reliable electrical connection between connector units with smaller insertion and withdrawal forces than previously required.

An embodiment of the present invention can provide a connecting device which can ensure satisfactory insertion of connector units and excellent operationability.

An embodiment of the present invention can provide a structure for establishing reliable electrical connection between a cassette type magnetic bubble memory unit and a connector unit consisting of a holder unit which accommodates the memory unit when the memory unit and holder unit are connected. Such an embodiment has a smaller insertion force (and withdrawal force) and also provides an operator with sufficient "feel" to enable the operator to sense that insertion has been properly accomplished, with excellent operationability.

An electrical connecting device embodying the present invention has a structure such that the electrical terminals of a first connector unit and a second connector unit are connected by inserting the first connector unit into an accepting port of the second connector unit, wherein a rotating member, providing coupling means which couples with the first connector unit, is provided within the second connector unit, the rotating member rotating in accordance with the inserting operation of the first connector unit and simultaneously couples with the first connector unit, pushing it in the insertion direction.

This invention can bring about various advantages where an electrical connecting device embodying the invention has a first connector unit comprising a cassette type magnetic bubble memory unit accommodating a magnetic bubble memory element, and a second connector unit comprising a holder unit which allows insertion there into of the bubble memory unit and connects the bubble memory unit to a main apparatus.

Reference is made, by way of example, to the accompanying drawings, in which:—

Fig. 1 is a schematic block circuit diagram of a cassette type magnetic bubble memory system in which an embodiment of the present invention is employed,

Fig. 2 is a perspective view of a cassette type magnetic bubble memory unit proposed in the applicant's United States Patent Application Serial No. 192,804, filed October 1, 1980, entitled "Magnetic Bubble Memory Device".

Fig. 3 is a schematic side view of the proposed memory unit and a holder unit therefor, in a deposition in which electrical connection is not established,

Fig. 4 is a perspective view of a cassette type magnetic bubble memory unit in accordance with an embodiment of the present invention,

Fig. 5 is a plan view, from below, of the memory unit of Fig. 4,

Fig. 6 is an exploded perspective view of the memory unit of Fig. 4,

Fig. 7 is a sectional view of the interior of the memory unit of Fig. 4,

Fig. 8 is a perspective view showing a magnetic bubble element accommodated within the memory unit of Fig. 4,

Figs. 9(A) to 9(C) illustrate an embodiment of the present invention in which a cassette type magnetic bubble memory unit and a holder unit are provided:

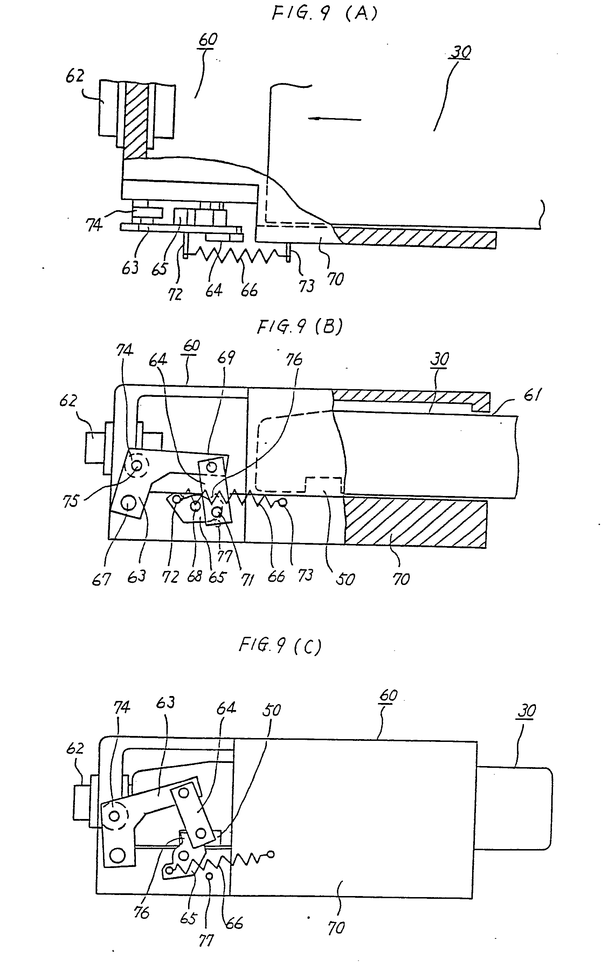

Fig. 9(A) is a partial plan view of the memory unit and holder unit before electrical connection is established between them; Fig. 9(B) is a side view corrresponding to Fig. 9(A), Fig. 9(C) is a side view after electrical connection is established.

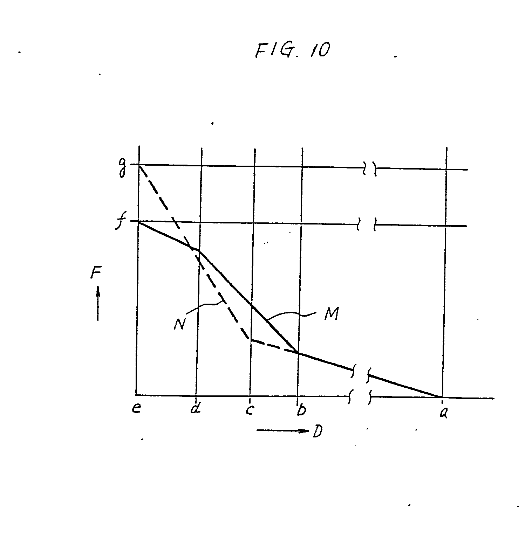

Fig. 10 is a group illustrating the insertion force characteristic for a memory unit in an embodiment of the present invention,

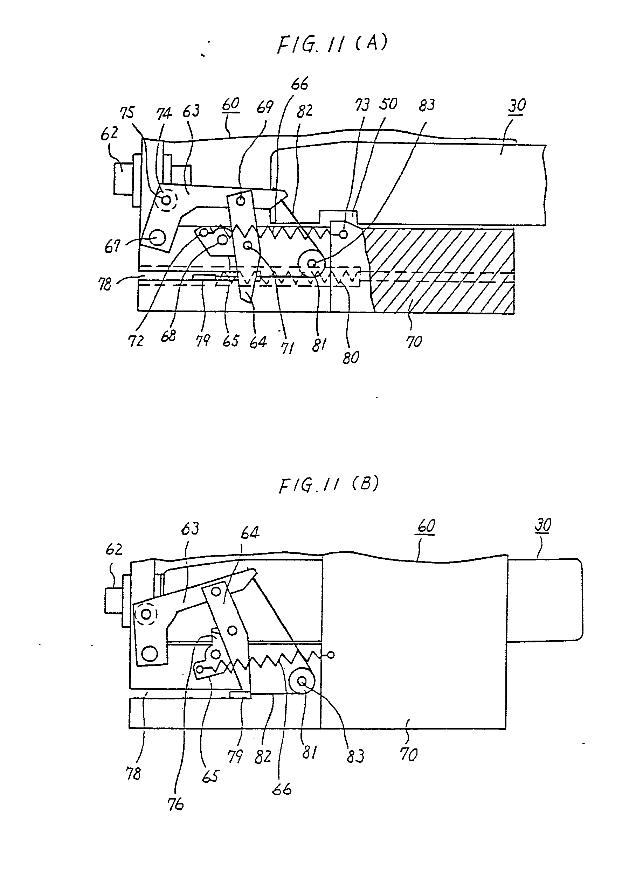

Figs. 11(A) and 11(B) illustrate another embodiment of the present invention: Fig. 11(A) is a side view of a memory unit and a holder unit before electrical connection is established; and Fig. 11(B) is a side view after electrical connection is established,

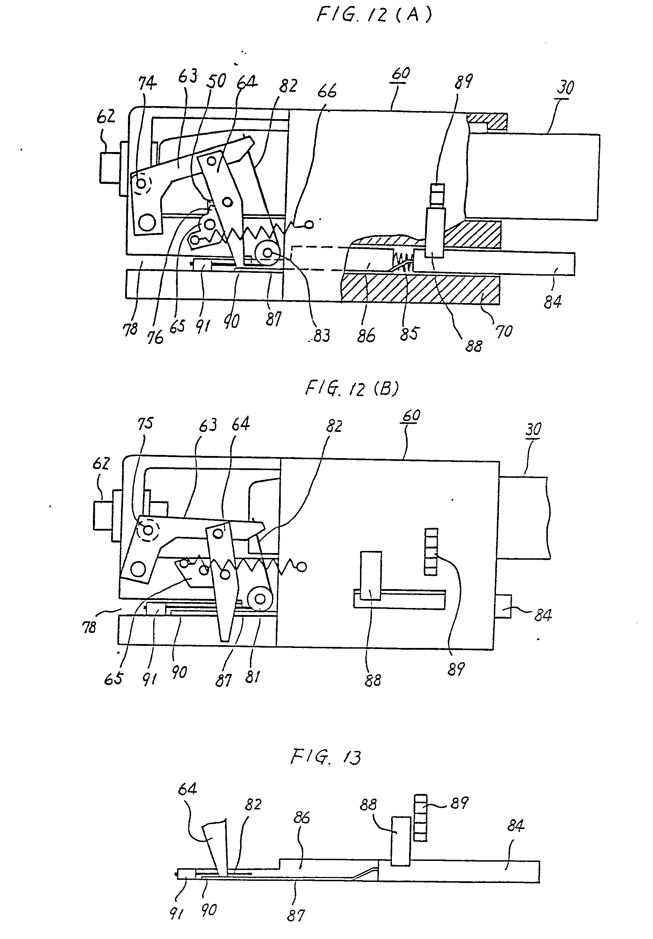

Figs. 12(A) and 12(B) illustrate a further embodiment of the present invention: Fig. 12(A) is a side view after electrical connection is established; and Fig. 12(B) is a side view after electrical connection has been reset,

Fig. 13 is a schematic side view of a slider of the embodiment of Figs. 12(A) and 12(B), for resetting electrical connection,

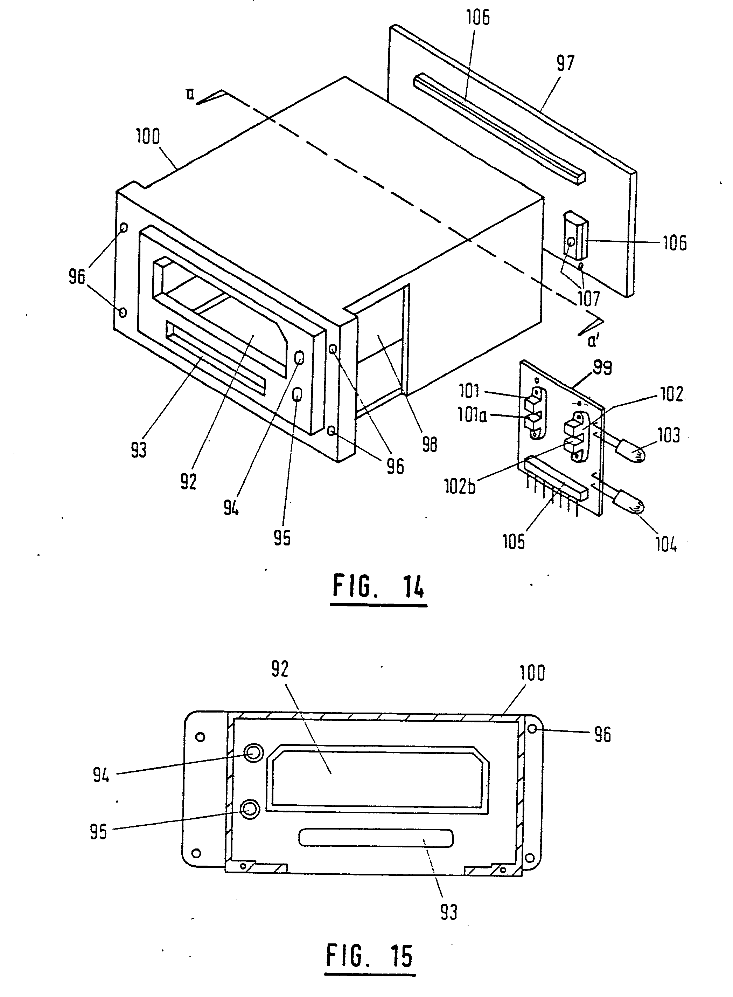

Fig. 14 is a perspective view of a disassembled holder case of an embodiment of the present invention showing an example of a practical structure thereof,

Fig. 15 is a sectional view of the holder case, taken along the line a—a' in Fig. 14 and viewed from the direction indicated by arrows in Fig. 14,

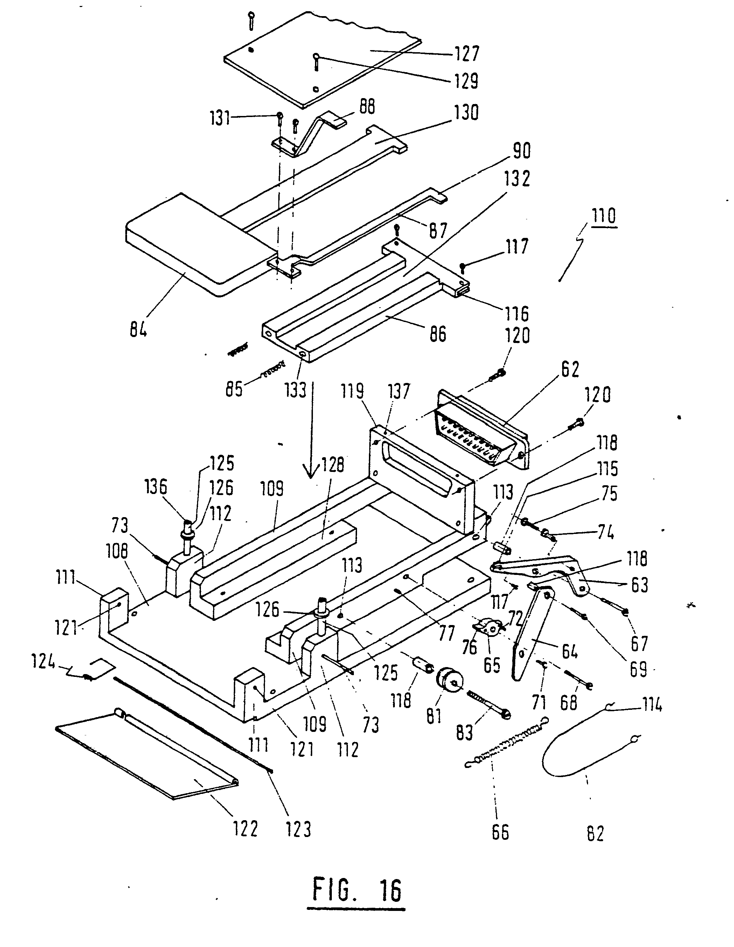

Fig. 16 is a perspective view of a disassembled holder unit in accordance with an embodiment of the present invention, which holder unit is accommodated within the case of Fig. 14,

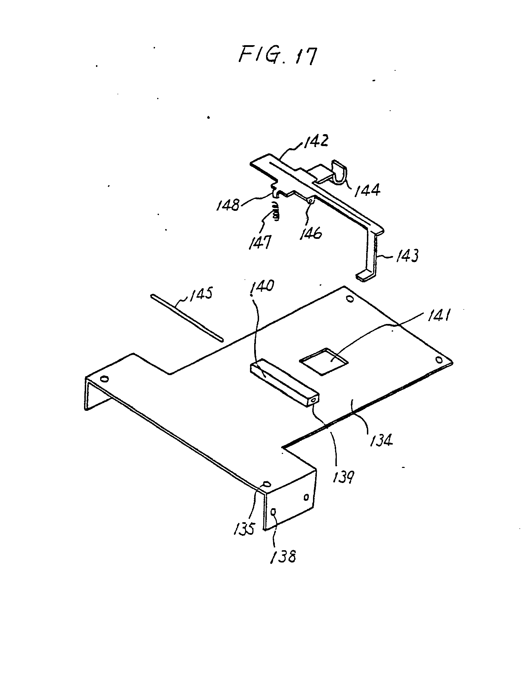

Fig. 17 is a perspective view of a disassembled cover of the holder unit of Fig. 16, and

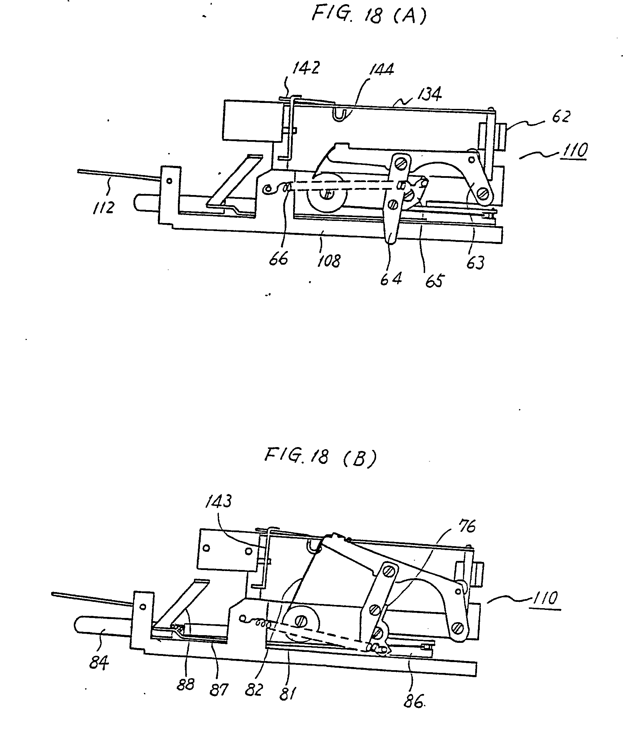

Figs. 18(A) and 18(B) are respective side views of a holder unit in accordance with an embodiment of the present invention: Fig. 18(A) illustrates an operating condition before a cassette is inserted into the holder unit; and Fig. 18(B) illustrates an operating condition after the cassette is inserted.

The present invention can be adopted in any circumstances requiring an electrical connecting device or structure or arrangement for establishing electrical connection between terminals of first and second connector units by inserting the first unit into the second unit, but the present invention will be explained below in relation to cassette type magnetic bubble memory systems.

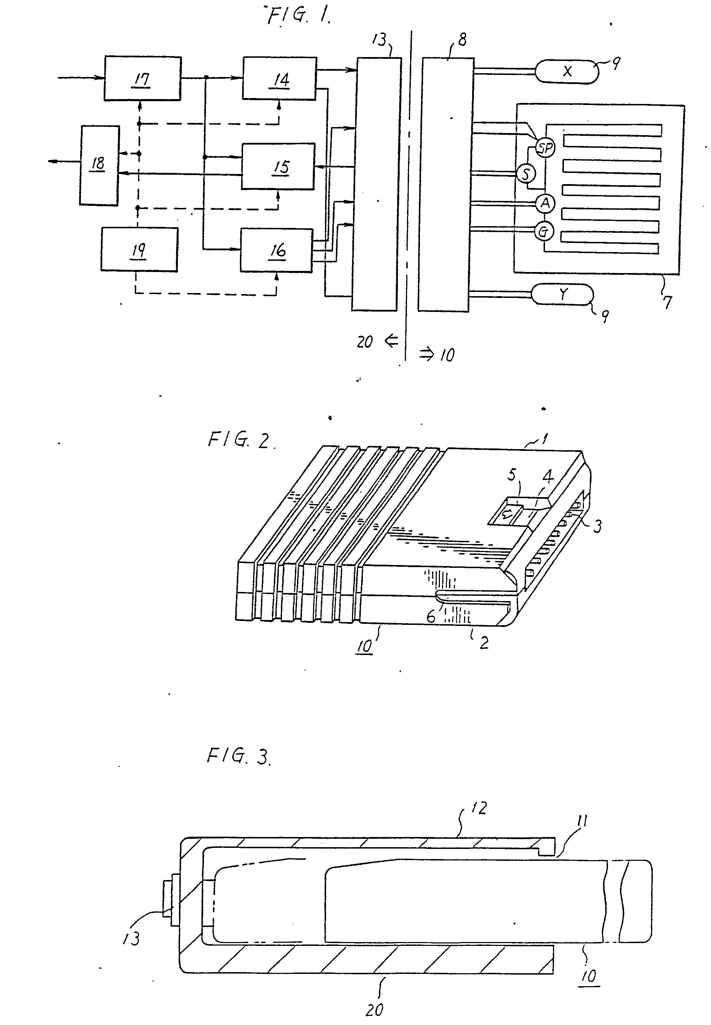

Fig. 1 is a schematic block circuit diagram of an example of a bubble memory system — in which an embodiment of the present invention is employed.

In Fig. 1, 10 is a cassette type magnetic bubble memory unit, 20 is a holder unit which is a terminal of a main unit with which the bubble memory unit is employed. 7 is a bubble memory chip having functional sections such as a magnetic bubble generator G, a bubble splitter SP, a sensor S and an eraser A.

In Fig. 1, the buble memory chip 7 has a single loop structure but it can alternatively have a major-minor loop structure. 8 is a connector providing thereon electrical terminals; 9 is a rotating field generating coil comprising X and Y coils arranged so as to cover the bubble memory chip. The magnetic bubble memory element comprises the bubble memory chip 7, coil 9 and a bias magnet packaged within a shield case.

13 is a connector of the holder unit 20 providing electrical terminals corresponding to those of the connector 8 on the bubble memory unit 10, 14 is a coil driving circuit which generates a rotating field along the bubble memory chip surface by supplying a sine wave current or a triangular current, 15 is a bubble readout circuit, 16 is a magnetic bubble control circuit comprising a bubble write circuit for generating bubbles by supplying a current to magnetic bubble generator G, a circuit for splitting bubbles by supplying current to splitter SP, a circuit for detecting bubbles by supplying current to sensors S and a circuit for erasing unwanted bubbles by supplying current to eraser A. 17 is a control circuit which controls the coil drive circuit 14, bubble readout circuit 15 and magnetic bubble control circuit 16 in accordance with commands sent from a central processing unit. 18 is a register and 19 is a current circuit.

Such a structure makes it possible to connect a comparatively small size and portable bubble memory unit 10 to the holder unit 20 via the connectors 8 and 13 and also to drive the bubble memory element in the unit 10 via the unit 20 in accordance with a control signal sent from a main device.

As shown in Fig. 2, an existing bubble memory unit has a structure in which the magnetic bubble memory element (not illustrated) is accommodated within a space formed by upper and lower cases 1, 2 which are both formed in accordance with a box type mold. A plurality of slide contact type electrical terminals 3 forming a connector 8 (refer to Fig. 1) are provided at an insertion end of the bubble memory unit.

The upper case 1 has an indentation (concavity) 4 in its external surface at the insertion end of the unit and a slide plate 5, for setting a bubble data write inhibit condition or a bubble data write ready condition, is located freely slidably in the indentation (recess) 4.

Moreover, assembled together, upper case 1 and lower case 2 provide guide grooves 6 for preventing misinsertion. Respective guide grooves of different widths are provided on opposite sides of the unit (only one can be seen in Fig. 2).

As shown in Fig. 3, the existing holder unit 20 provides a molded holder case 12 having an insertion port 11 for receiving a bubble memory unit and used in such a manner that the holder case 12 is mounted in a panel surface of a main device. The connector 13 which provides electrical connection terminals (not illustrated) corresponding to electrical terminals 3 having a spring property is provided rearwardly of insertion port 11. In the existing structure, a bubble memory unit 10 outlined in Fig. 3 is inserted into the insertion port 11 and electrical connection is obtained by sliding contact of the electrical terminals of the two units 10 and 20. In such an existing structure, electrical terminals 3 are constituted by plug terminals, whilst electrical terminals of connector 13 are constituted by jack terminals. The structure whereby a plug terminal is inserted into a jack terminal assures excellent reliability of electrical connection between those terminals and maintenance of a stable contact condition in the face of external vibrations to some extent.

However, the existing structure requires large insertion and withdrawal forces. In addition, with this structure the insertion force becomes gradually larger as insertion proceeds, and an operator feels uneasy because of the poor 'feel' which accompanies insertion, as a result there is always a risk that an insertion operation will be carried out with an excessive insertion force. Moreover, since a locking mechanism for reliably maintaining a perfect contact condition is not provided, imperfect connection, resulting in a system in which the cassette unit is used going down, can arise due to withdrawal occurring naturally as a result of external vibration.

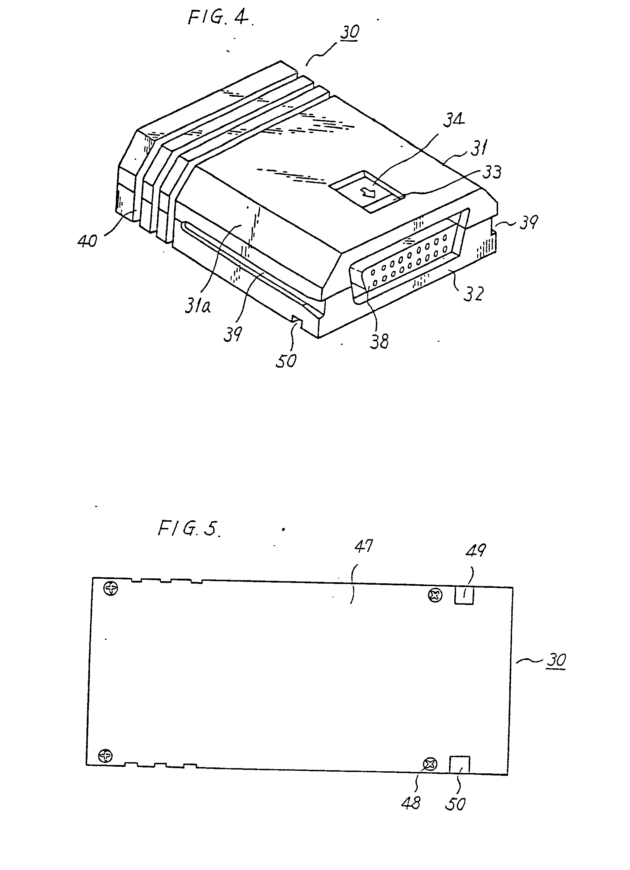

Figs. 4 to 8 illustrate a cassette type magnetic bubble memory unit in accordance with an embodiment of the present invention.

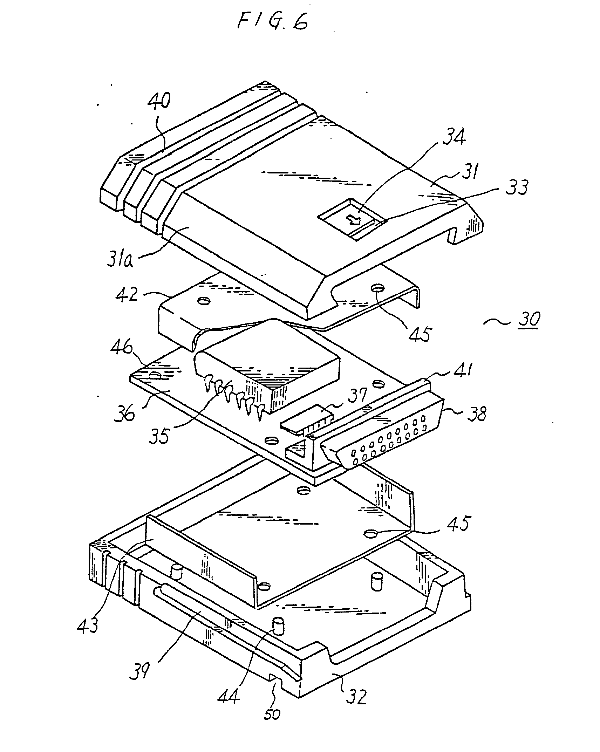

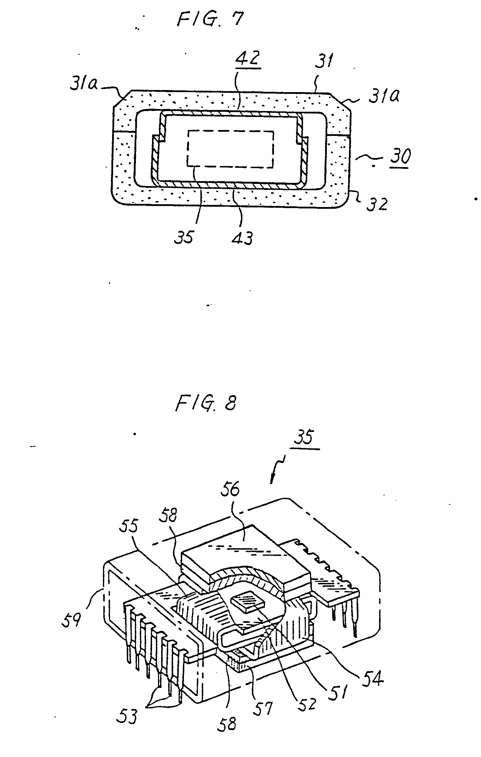

The memory unit 30 of Figs. 4 to 8 resembles the existing unit 10 of Fig. 2, but is externally different particularly in that a pair of coupling grooves or recesses 49 and 50 are provided. The grooves or recesses 49 and 50 are provided towards the insertion end of the unit in the lower surface 47 of a lower case part 32 in the form of a recess or concavity. 31 and 32 are molded upper and lower case parts of memory unit 30. These parts are similar to those of the existing (see Fig. 2) unit but, as will be particularly seen in the outline view of Fig. 4, the upper case 31 is formed asymmetrically with external surfaces 31a provided with a large chamfer in order to prevent reverse insertion of the cassette unit. As explained above, a cassette accepting port of a holder is so formed as to engage with the external shape of the cassette unit. 33 is a recess or concavity, 34 is a slide plate used as a write inhibit member, 35 is a magnetic bubble memory element armoured by a shield case, 36 is a PC board mounting the magnetic bubble memory 35 and a sense amplifier IC 37 for the bubble memory. 38 is a connector which is a female connector provided with jack terminals. The reason why such a female connector is used on the cassette unit is that the jack terminal of a female connector is held within an insulator member, which differs from the structure of a plug terminal which projects beyond a male connector, and therefore by using a female connector on the cassette unit there is a reduced chance of personnel directly touching terminals with bare fingers, thereby reducing the possibility of electrostatic breakdown of IC 37. Guide grooves 39 are provided on both side of the cassette unit, the grooves having different widths for preventing mis-insertion. 40 is a slide stop groove, 41 is a connector mounting board, 42 and 43 are magnetic shield plates composed of ferro-magnetic material of high permeability and having substantially ]-shaped sections. The shield plates 42 and 43 are, as shown in the sectional view of Fig. 7, arranged in such a way as to surround the memory element 35 in the cassette unit. As shown in Fig. 6, the shield plates 42, 43 are mounted by inserting projections 44 (projections on the upper case 31 are not illustrated), which are formed, for example integrally, on internal surfaces of the upper and lower case parts 31, 32, into holes 45 in the shield plates and then the upper parts of the projections 44 are thermally caulked. In this case, projections 44 for locating the lower shield plate 43 pass through holes 46 in the PC board 36 which is simultaneously located by those projections. Moreover, the shield plates 42 and 43 overlap, as illustrated in Fig. 7, so that their ends do not collide when the upper and lower case parts 31 and 32 are coupled together by means of screws 48 (refer to Fig. 5) and so that a double thickness is provided of shielding material where the shield plates overlap. Thereby an excellent magnetic shielding effect can be obtained.

As shown in Fig. 8, the memory element 35 comprises an insulating PC board 52, carrying a magnetic bubble memory chip 51 and lead terminals 53, house within a magnetic shield case 59, in which an X coil 54 and a Y coil 55 (for generating a rotating field), bias magnets 56 and 57 and upper and lower pairs of magnetic field regulating plates 58, are packaged.

It is to be particularly noted that the memory unit 30 described in detail with reference to Figs. 4 to 8 has coupling grooves 49 and 50 at the surface of the case.

Figs. 9(A) to 9(C) illustrate a holder unit of a cassette type magnetic bubble memory device embodying the present invention. The holder unit 60 is for receiving the abovementioned memory unit 30.

The holder unit 60 has a molded box type holder case 70 open at the front at which it provides an accepting port 61 for a memory unit. Moreover, at the rear of the case 70, a male connector 62 providing plug terminals (not illustrated) is located. In addition, on both sides at the rear of the case 70 a coupling mechanism for a memory unit 30 is provided. At one side the coupling mechanism comprises an L-shaped metal lever 63, a metal lever 64, a resin molded rotating member 65 and a tensile coil spring 66. The lever 63 is mounted at the one end, freely rotatably relative to the case 70, by means of a shaft 67. The rotating member 65 is also mounted, at its center, with freedom of rotation relative to the case 70, by means of a shaft 68. The lever 64 couples the other end of lever 63 and one end of rotating member 65 via rotating shafts 69 and 71. The coil spring 66 is extended between a pin 72 mounted on the other end of the rotating member 65 and a pin 73 mounted on the case 70. Moreover, the lever 63 is provided with, at the center of its internal surface, a roller 74 (with which the end tip of memory unit 30 collides when inserted) by means of a shaft 75 and, on the other hand, the one end of the rotating member 65 is provided with a projecting hook 76 for coupling with a groove or recess 50 in a memory unit 30. Furthermore, the coil spring 66 is located on the upper side of the shaft 68 as shown in Figs. 9(A) and 9(B) when the rotating member 65 is in a stationary condition. Therefore, the rotating member 65 is pulled by the coil spring 66 and urged to rotate in the clockwise direction, its rotation angle being predetermined by a stop pin 77.

When a memory unit 30 is initially inserted into such a holder unit 60 conditions as shown in Figs. 9(A) and 9(B) are established. When the memory unit 30 is further inserted, the end surface of the unit 30 comes into contact with the roller 74. When it is still further inserted, the roller 74 is pushed, and moves backwards. Thereby the lever 63 rotates through a specified angle, rotating the rotating member 65 via the lever 64. At this time, the coil spring 66 is slightly elongated with the centers of the shaft 68 and pins 72, 73 located along the same straight line and the tensile force exerted by spring 66 is somewhat. increased. Thus, the hook 76 of rotating member 65 is engaged, at its point, with the groove 50 of the memory unit 30. When the center of pin 72 is below the extension of the line connecting the centers of shaft 68 and pin 73, the rotating member 65 is pulled by the coil spring 66 and rotated in a counterclockwise direction. This rotating operation causes the hook 76 to further engage with the groove 50, pulling the memory unit 30 in the direction of insertion and resulting in the condition shown in Fig. 9(C).

That is, a tensile force exerted by coil spring 66 working in a direction opposing the insertion direction during initial insertion of the memory unit 30, then works in the insertion direction when the rotating member 65 has rotated through the specified angle. Thereby, as shown in Fig. 9(C), the memory unit 30 is perfectly inserted into the holder unit 60 and the connectors of the two units are electrically connected.

When the memory unit 30 is manually inserted, an operator will feel a snap action, which means that insertion force suddenly becomes light, when the direction in which tensile force of coil spring 66 works changes. This provides a clear 'feel' for the operator to judge insertion and imperfect insertion can be eliminated by the provision of such snap action in the insertion operation.

Moreover, since engagement between the hook 76 and groove 50 is maintained by the tensile force of coil spring 66, a connection which is stable in the face of external vibration can be obtained. Tensile force of the spring results in an alleviation of the insertion force.

Withdrawal of memory unit 30 from the holder unit 60 can be effected by pulling upon the unit 30, holding that part of the unit which projects from the front of unit 60 (see Fig. 9(C)).

Fig. 10 is a graph illustrating the relationship between insertion force F (vertical axis) and insertion distance D (horizontal axis), for memory unit 30 when inserting the memory unit 30 into the holder unit 60. In Fig. 10, the characteristic M indicated by a solid line relates to an embodiment of the present invention, while the characteristic N indicated by a broken line relates to the existing device shown in Fig. 3. In addition, point a on the horizontal axis (insertion distance D) corresponds to an insertion start point point b corresponds to a contact start point (start of contact between memory unit 30 and roller 74), point c corresponds to a contact start point for electrical terminals of the two units, point d corresponds to a point at which the direction of the tensile force of the coil spring 66 is inverted, and point e corresponds to the completion of contact between the electrical terminals of the two units. On the other hand, point f on the vertical axis (insertion force F) indicates insertion force when insertion corresponding to characteristic M is completed, whilst point g indicates insertion force when insertion corresponding to characteristic N is completed.

As will be clear from Fig. 10, insertion force in accordance with characteristic M increases quickly as compared with that of characteristic N, but the rate of increase rapidly falls after the point d. At the point e, at which insertion is complete, insertion force in the embodiment of the present invention is reduced by 20% or more as compared with the existing device.

Figs. 11(A) and 11(B) illustrate another cassette type magnetic bubble memory device in accordance with another embodiment of the present invention. The device of Figs. 11 differs from the embodiment of Figs. 9 in that the coupling mechanism, for the memory unit, provided in the holder unit 60 has stopper means.

Such stopper means has a structure in which a through hole 78 is provided at the bottom of case 70 and a slider 79 and a coil spring 80 urging the slider downward are arranged within the hole 78. The slider 79 and the end of lever 63 are moreover connected by means of a metal wire 82 via a roller 81. The roller 81 can freely rotate on a shaft 83.

In the stationary condition shown in Fig. 11(A), the slider 79 is located backwardly of the lever 63 by means of the tensile force of coil spring 80. When the memory unit 30 is inserted further beyond this condition, the slider 79 is pulled forward by means of the wire 82 due to the rotating operation of the rotating member 65 and lever 63. When the memory unit 30 is inserted, the slider 79 enters below the end of lever 64 which is moved upwards (as compared with Fig. 11(A)) as shown in Fig. 11(B). In this condition, the lever 64 is locked and cannot be restored, resulting in a stop operation. Thus, when once the memory unit 30 is inserted perfectly, it cannot be withdrawn even if it is pulled by grasping the part thereof projecting beyond the holding unit 60, because the lever 64 is engaged by the slider 79.

For withdrawal of memory unit 30 it is necessary to restore the engagement of lever 64 (free the lever from engagement by slider 79) by inserting a rod wrench (not illustrated) for example into the through hole 78 from the front of case 70 and pushing the slider 79 backwards via the coil spring 80. This done, the memory unit 30 can be removed.

The embodiment of the present embodiment of Figures 11 prevents natural withdrawal due to external vibration and also prevents careless withdrawal.

Figs. 12(A), 12(B) and Fig. 13 illustrate another cassette type magnetic bubble memory device embodying the present invention.

This device of Figs. 12(A), 12(B) and 13 offers improved stopper means as compared with the device of Figs. 11.

The stopper means comprise an eject button 84, a specified length of which projects from the front surface of holder unit 60, an eject slider 86 which is connected to the eject button 84 via a coil spring 85, and a lock slider 87, of which the front end is fixed to the eject button 84, accommodated within the through hole 78. The eject button 84, moreover, is provided with a photo-cam 88 fixed and projecting from its side (to the front of the surface on which the Figure is provided). Moreover, a photo-sensor 89 is provided at the side of holder unit 60.

As shown in Fig. 12(A), when the memory unit 30 is inserted into the holder unit 60, the end of photocam 88 is inserted into the middle of photo-sensor 89.

As explained previously, the rotating member 65 rotated by means of tensile force of coil spring 66, engages the hook 76 with the groove 50 and establishes electrical connection of memory unit 30. Simultaneously, the rotated lever 63 pulls forward the eject slider 86 and the eject button 84 through the wire 82. Thereby, an end 90 of lock slider 87 (projected to the front side of figure surface) enters beneath the end of lever 64, locking the memory unit 30. This locked condition and the electrical connecting condition are indicated by the photo-sensor 89. 91 is an end of eject slider 86 to which the end of wire 82 is fixed.

The memory unit 30 can easily be withdrawn from the holder unit by pushing the eject button 84 and then pulling the unit 30 out, by grasping that part of the unit 30 projecting from the front of the holder unit 60. Namely, when the eject button 84 is depressed, as shown in Fig. 13, the coil spring 85 is compressed and the rear surface of eject button 84 comes into contact with the front surface of eject slider 86. The lower end surface of photo-sensor 89, the photo-cam and lever 64 and the end 90 of lock slider 87 are respectively placed in a zig-zag condition (in a condition as shown in Fig. 13). As a result, the photo-sensor 89 sends first a signal indicating withdrawal of the cassette unit 30 and simultaneously the lever 64 is unlocked. Then, when the eject button 84 is further depressed, the eject slider 86 moves backward and thereafter the wire 82 fixed to the end 91 is pulled backwards.

Thereby, the lever 63 and rotating member 65 rotate as shown in Fig. 12(B), and the memory unit 30 can be withdrawn.

For withdrawal of the memory unit 30, the pressure force (withdrawal force) to be applied to the eject button 84 can easily be set to 1/3 or less of the above-mentioned insertion force by means of the coupling lever ratio of the levers 63, 64, rotating member 65 and and the roller 81.

With the embodiment of Figs. 12 and 13 withdrawal operations for memory unit 30 becomes easy as compared with those for the device of Fig. 11. At the time of withdrawal operation, a lock restoration signal is generated before the electrical connection of memory unit 30 becomes OFF (is broken), and the bubble data of memory element 35 can be protected from careless withdrawal operation.

Figs. 14 to 18 show a practical structural example of the holder unit 60 of Figs. 12.

Figs. 14 and 15 illustrate a holder case 100 of holder unit 60.

The case 100 is a resin molded box type case and its front side is provided with an accepting port 92 for a memory unit 30, a projecting port 93 for an eject button, light emitting diode insertion holes 94 and 95 and holes 96 for fixing the case. The rear of the case itself is open but is blanked by a metal plate 97. Towards the front on one side of the case is formed an opening port 98 which is blanked by a print board 99. The print board 99 carries a couple of photo-sensors 101, 102, light emitting diodes 103, 104 and a connector 105. This print board is mounted on the case 100 with elements mounted on the board placed internally of the case. The light emitting diodes 103, 104 indicate magnetic bubble drive condition and data write condition. One photo-sensor 101 provides detection in relation to the slide plate 34 of a memory unit 30, whilst the other photo-sensor 102 detects the condition of the eject button. In addition, the photosensors 101 and 102 detect the conditions of the relevant integers at their centers 101a, 102b.

The metal plate 97 is provided internally with projections 106 for preventing bending of the case 100 and a hole 107 for a fixing screw.

As illustrated in Fig. 16, a holder unit 110 accommodated within the case 100 includes a plurality of parts mounted on a base plate 108 of machined metal.

On the surface of base plate 108, mounting plate pairs 109, 111, 112 are provided. On a mounting plate 109, levers 63, 64, rotating member 65 and roller 81 are mounted by means of shafts 67, 68, 69, 71 and 83. Fig. 16 shows the lever 63 for one mounting plate 109; such a lever (not shown) is also provided on the outermost side of the other mounting plate 109. The lever 63 is provided with roller 74 on shaft 75 and coil spring 66 is extended between pins 72 and 73. The mounting plate 109 is provided with holes 113 into which the shafts 67, 68, 83 are screwed and with stop pin 77. Metal ball stoppers 114 are fixed to both ends of the metal wire 82, and the metal balls 114 are placed in a groove 115 in an end of lever 63 and in a groove 116 in eject slider 86 and are stopped by pins 117. 118 indicates metal rings. At the rear side of mounting plates 109, a mounting plate 119 for connector 62 is fixed by means of screws 120. In holes 121 of mounting plates 111, a cover 122 which blanks the accepting port 92 from the rear thereof is supported by a shaft 123. A twisting spring (screw) 124 is provided on the shaft 123, pressing the cover 122 into the accepting port 92. The cover 122 usually blanks the accepting port 92 under the pressure of spring 124 but falls down inside the housing case when a memory unit 30 is inserted into the accepting port 92. When the memory unit 30 is removed, the cover 122 once again blanks the accepting port 92 on account of action of the spring 124.

On the mounting plates 112, poles 125 are fixed which engage with guide grooves 39 of a memory unit 30 and which have resin rings 126 fixed thereto for guiding the unit 30.

The mounting plates 109 provide for arrangement of eject slider 86, eject button 84 and cover 127. The cover 127 is fixed to parts 128 different in level from other parts of mounting plates 109 by screws 129. The eject button 84 is provided with a guide plate 130 and lock slider 87, and the slider 87 has photo-cam 88 fixed thereto by screws 131. The photo-cam 88 corresponds to the detector 102b of photo-sensor 102 at a horizontal end portion of the cam. The guide plate 130 and slider 87 are formed by punching sheet metal plate and their edges are inserted into the eject button at the time of resin molding the eject button 84. An edge 90 of the slider 87 is bent to form a lozenge-shape whereby lever 64 can be locked. On the surface of slider 86, a guide groove 132 for guide plate 130 is formed, while at the edges of slider 86 holes 133 accommodating springs 85 are formed.

The stopper mechanism is assembled as follows. The eject slider 86 is placed on the base plate 108 between the mounting plates 109 and the eject button 84 is placed thereon. The eject button 84 is placed with guide plate 130 in groove 132 and the slider 87 arranged between mounting plates 109 and 112. Moreover springs 85 are provided between the slider 86 and eject button 84. Thereafter, the cover 127 is mounted and thereby the eject button 84 and slider 86 can freely slide between the base plate 108 and cover 127. The cover 134 indicated in Fig. 17 is mounted on the holder 110. The cover 134 is fixed by screwing, holes 135 at its four corners matching holes 136 in poles 125 and holes 137 in mounting plate 119. A hole 138 is a screw hole for fixing the print board 99. On the surface of cover 134, a support plate 140 providing a through hole 139 is fixed, and a hole 141 is provided in that surface.

Moreover, on the surface of cover 134, a detecting plate 142 is mounted. The detecting plate 142 is formed by punching and bending metal plate. At an edge part of the plate 142, photo-cam 143 is formed and at its center a detection tip 144 for the slide plate 34 of a unit 30 is provided. A horizontal end portion of photo-cam 143 corresponds to the detector 101a of photo-sensor 101. The detecting plate 142 allows the detecting tip 144 to project downwardly through the hole 141 and is mounted with freedom of rotation with the photo-cam 143 hanging downwards. Namely, the detecting plate 142 is mounted as follows. A shaft 145 is inserted into the through hole 139 and projecting ends of the shaft are inserted into holes (146) in detecting plate 142. A coil spring 147 is supported by a projecting tip 148, urging the detecting tip 144 downwardly.

Figs. 18(A) and 18(B) illustrate the holder unit 110 when assembled. Fig. 18(A) illustrates a condition before insertion of a memory unit 30; the same condition as illustrated by Fig. 12(B). Fig. 18(B) illustrates a condition after insertion of memory unit 30; the same condition as illustrated by Fig. 12(A).

A holder unit 60 comprises the holder unit 110 of Fig. 18 in the holder case 100 of Fig. 14, fixed by screwing, and also comprises the metal plate 97 and print board 99.

When a memory unit 30 is inserted into the holder unit 60, the hook 76 of rotating member 65 engages with the groove 50 as explained above, for locking. This condition is maintained by stopper means. The memory unit 30 can be withdrawn by removing the stopper by pressing the eject button 84 and rotating the rotating member 65 counter clockwise.

If the slide plate 34 of a memory cassette 30 blanks the recess or concavity 33 of the cassette the detecting tip contacts the slide plate 34 and therefore the detecting plate 142 is rotated. Thereby photo-cam 143 is removed from the photo-sensor 101 and a bubble data read-in signal, for example, is transmitted. On the other hand when the slide plate 34 does not blank the recess 33, the detecting plate 142 does not rotate, the photo-cam 143 is detected by the photo-sensor 101, and thereby a bubble data read inhibit signal is transmitted.

When the memory unit 30 is inserted, the photo-cam 88 is located forwardly and within the photo-sensor 102. When the eject button 84 is operated, the photo-cam 88 moves backwardly as shown in Fig. 18(A), and is removed from the photo-sensor 102. Thereby, a memory unit restoring signal is generated by the photo-sensor 102.

An embodiment of the present invention relates to an electrical connecting device which provides electrical connection of a first connector unit and a second connector unit by inserting the first connector unit into an accepting port of the second connector unit. This electrical connecting device has a rotating member providing a coupling portion which engages with the first connector unit, within the second connector unit. This rotating member rotates as inserting operation of the first connector unit proceeds, and engages with the first connector unit, urging the first connector unit in the insertion direction.

## Claims

1. An electrical connecting arrangement, comprising first and second connector units (30, 60), electrical terminals of which are connected by inserting the first connector unit (30) into the second connector unit (60), and a rotatable member (65) within the second connector unit (60), providing a coupling part (76) for engagement with the first connector unit (30), the rotatable member (65) being arranged to be rotated by the insertion movement of the first connector unit (30) into the second connector unit, the rotation of said rotatable member causing the coupling part (76) to engage with a recess (49, 50) in the first connector unit, characterised in that spring means (66) are provided to urge the first connector unit in the direction of insertion via said engagement.

2. An arrangement as claimed in claim 1, wherein the rotatable member (65) is provided with a hook (76) which acts as the coupling part, the hook engaging the recess (49, 50) as the first connector unit (30) is inserted into the second connector unit (60).

3. An arrangement as claimed in claim 1 or 2, wherein the second connector unit (60) comprises a rotatably mounted lever (63), coupled to the rotatable member (65), arranged so that the lever (63) is pushed by the first connector unit (30) by the insertion movement of that unit into the second connector unit (60), and thereby causes the rotatable member (65) to rotate so as to urge the first connector unit (30) in the direction of insertion.

4. An arrangement as claimed in any preceding claim, wherein the second connector unit (60) comprises a slider (79, 87) arranged for co-operation with the rotatable member (65) such that upon rotation of the rotatable member (65) the slider (79, 87) moves to a disposition in which it locks the rotatable member (65) in position, with the coupling part (76) engaged with the first connector unit (30) fully inserted in the second connector unit (60).

5. An arrangement as claimed in claim 4, wherein the second connector unit (60) is provided with an eject button (84) operable to move the slider (87) from the said disposition to unlock the rotatable member (65).

6. An arrangement as claimed in claim 5, wherein the eject button (84) is operable to unlock the rotatable member (65) and simultaneously to disconnect electrical terminals of the first and second connector units for withdrawal of the first connector unit from the second connector unit.

7. An arrangement as claimed in claim 6, wherein the eject button (84) has a photo-cam (88) co-operating with a photo-sensor (89) of the second connector unit (60), whereby a lock release signal can be provided when the eject button (84) is operated.

8. An arrangement as claimed in claim 7, wherein the lock release signal is provided before electrical terminals of the first and second connector units are disconnected.

9. An arrangement as claimed in claim 2, wherein the first connector unit (30) is provided with respective recesses (49, 50) on opposite sides thereof, and the second connector unit (60) has a pair of rotatable members (65), provided with respective hooks (76) which engage the respective recesses (49, 50) of the first connector unit (30) by the insertion movement of the first connector unit (30) into the second connector unit (60).

10. An arrangement as claimed in any preceding claim, wherein the first connector unit (30) is a cassette type magnetic bubble memory unit, and the second connector unit (60) is a holder unit for accommodating the memory unit.

11. A first connector unit for an arrangement as claimed in any preceding claim.

12. A second connector unit for an arrangement as claimed in any preceding claim.

## Revendications

1. Ensemble de connexion électrique, comprenant une première et une deuxième unité de connecteur (30, 60), dont on connecte des bornes électriques par insertion de la première unité de connecteur (30) dans la deuxième unité de connecteur (60), et un élément pouvant tourner (65) situé à l'intérieur de la deuxième unité de connecteur (60) qui fournit une partie de couplage (76) destinée à venir en prise avec la première unité de connecteur (30), l'élément tournant (65) étant conçu pour être entraîné en rotation par le mouvement d'insertion de la première unité de connecteur (30) dans la deuxième unité de connecteur, la rotation dudit élément tournant amenant la partie de couplage (76) à venir en prise avec un évidement (49, 50) ménagé dans la première unité de connecteur, caractérisé en ce que des moyens qui constituent un ressort (66) sont prévus pour pousser la première unité de connecteur dans la direction d'insertion par l'intermédiaire de ladite venue en prise.

2. Ensemble selon la revendication 1, où l'élément (65) pouvant tourner est doté d'un crochet (76) qui fait fonction de la partie de couplage, le crochet venant en prise avec l'évidement (49, 50) lorsque la première unité de connecteur (30) s'insère dans la deuxième unité de connecteur (60).

3. Ensemble selon la revendication 1 ou 2, où la deuxième unité de connecteur (60) comprend un levier (63) monté rotatif, couplé à l'élément pouvant tourner (65), ce levier étant conçu de façon à être poussé par la première unité de connecteur (30) lors du mouvement d'insertion de cette unité dans la deuxième unité de connecteur (60) et à amener ainsi l'élément tournant (65) à tourner de manière à pousser la première unité de connecteur (30) dans le sens d'insertion.

4. Ensemble selon l'une quelconque des revendications précédentes, où la deuxième unité de connecteur (60) comprend un curseur (79, 87) conçu pour coopérer avec l'élément pouvant tourner (65) de façon que, lors de la rotation de l'élément pouvant tourner (65), le glisseur (79, 87) se déplace jusqu'à une disposition dans laquelle il verrouille en position l'élément pouvant tourner (65), la partie de couplage (76) étant alors en prise avec la première unité de connecteur (30) complètement insérée dans la deuxième unité de connecteur (60).

5. Ensemble selon la revendication 4, où la deuxième unité de connecteur (60) est dotée d'un bouton d'ejection (84) ayant pour fonction de déplacer le curseur (87) hors de ladite disposition de manière à déverrouiller l'élément pouvant tourner (65).

6. Ensemble selon la revendication 5, où le bouton d'éjection (84) a pour fonction de déverrouiller l'élément pouvant tourner (65) et de déconnecter simultanément les bornes électriques des première et deuxième unités de connecteurs pendant l'opération consistant à enlever la première unité de connecteur de la deuxième unité de connecteur.

7. Ensemble selon la revendication 6, où le bouton d'éjection (84) possède une came photoélectrique (88) qui coopère avec un capteur photoélectrique (89) de la deuxième unité de connecteur (60), si bien qu'un signal de fin de verrouillage peut être produit lors de l'actionnement du bouton d'éjection (84).

8. Ensemble selon la revendication 7, où le signal indiquant la fin du verrouillage est produit avant la déconnexion des bornes électriques des première et deuxième unités de connecteurs.

9. Ensemble selon la revendication 2, où la première unité de connecteur (30) est dotée d'évidements respectifs (49, 50) sur ses côtés opposés, et la deuxième unité de connecteur (60) possède une paire d'éléments (65) pouvant tourner, qui sont dotés respectivement de crochets (76) qui viennent en prise avec les évidements (49, 50) respectifs de la première unité de connecteur (30) du fait du mouvement d'insertion de la première unité de connecteur (30) dans la deuxième unité de connecteur (60).

10. Ensemble selon l'une quelconque des revendications précédentes, où la première unité de connecteur (30) est une unité de mémoire à bulle magnétique du type cassette, et la deuxième unité de connecteur (60) est une unité de support destinée à loger l'unité de mémoire.

11. Première unité de connecteur destinée à un ensemble tel que défini dans l'une quelconque des revendications précédentes.

12. Deuxième unité de connecteur destinée à un ensemble tel que défini dans l'une quelconque des revendications précédentes.

**Patentansprüche**

1. Elektrische Verbindungsanordnung, mit ersten und zweiten Verbindungseinheiten (30, 60), deren elektrische Anschlüsse durch Einführen der ersten Verbindungseinheit (30) in die zweite Verbindungseinheit (60) verbunden werden, und einem rotierbaren Teil (65), innerhalb der zweiten Verbindungseinheit (60), welches einen Kupplungsteil (76) zum Eingriff mit der ersten Verbindungseinheit bildet, bei welcher das rotierbare Teil (65) so angeordnet ist, daß es durch die Einführungsbewegung der ersten Verbindungseinheit (30) in die zweite Verbindungseinheit rotiert wird, wobei die Rotation des genannten rotierbaren Teils bewirkt, daß das Kupplungsteil (76) mit einer Ausnehmung (49, 50) in der ersten Verbindungseinheit zum Eingriff kommt, dadurch gekennzeichnet, daß Federeinrichtungen (66) vorgesehen sind, um die erste Verbindungseinheit über den genannten Eingriff in Einführungsrichtung zu drängen.

2. Vorrichtung nach Anspruch 1, bei welcher das rotierbare Teil (65) einen Haken (76) aufweist, der als das Kupplungsteil wirkt und mit der Ausnehmung (49, 50) zum Eingriff kommt, während die erste Verbindungseinheit (30) in die zweite Verbindungseinheit (60) eingeführt wird.

3. Vorrichtung nach Anspruch 1 oder 2, bei welcher die zweite Verbindungseinheit (60) einen rotierbar gelagerten Hebel (63) umfaßt, der mit dem rotierbaren Teil (65) gekoppelt und so angeordnet ist, daß der Hebel (63) durch die Einführbewegung der ersten Verbindungseinheit (30) in die zweite Verbindungseinheit (60) von der ersten Verbindungseinheit geschoben wird und dadurch die Rotation des rotierbaren Teiles (65) bewirkt, um so die erste Verbindungseinheit (30) in Einführungsrichtung zu drängen.

4. Vorrichtung nach einem der vorhergehenden Ansprüche, bei welcher die zweite Verbindungseinheit (60) einen Schieber (79, 87) umfaßt, der zur Kooperation mit dem rotierbaren Teil (65) so angeordnet ist, daß bei Rotation des rotierbaren Teils (65) der Schieber (79, 87) sich in eine Stellung bewegt, in welcher er das rotierbare Teil (65) in seiner Position verriegelt, wobei der Kupplungsteil (76) mit der ersten Verbindungseinheit (30), die vollständig in die zweite Verbindungseinheit (60) eingeschoben wird, zum Eingriff kommt.

5. Vorrichtung nach Anspruch 4, bei welcher die zweite Verbindungseinheit (60) einen Auswerfknopf (84) aufweist, der betätigbar ist, um den Schieber (87) von der genannten Stellung bewegt, um das rotierbare Teil (65) zu entriegeln.

6. Vorrichtung nach Anspruch 5, bei welcher der Auswerfknopf (84) betätigbar ist, um das rotierbare Teil (65) zu entriegeln und gleichzeitig die elektrischen Anschlüsse der ersten und zweiten Verbindungseinheiten zu trennen, für die Entfernung der ersten Verbindungseinheit aus der zweiten Verbindungseinheit.

7. Anordnung nach Anspruch 6, bei welcher der Auswerfknopf (84) einen Fotonocken (88) aufweist, welcher mit einem Fotosensor (89) der zweiten Verbindungseinheit (60) zusammenwirkt, wodurch ein Entriegelungssignal vorgesehen werden kann, wenn der Auswerfknopf (84) betätigt wird.

8. Vorrichtung nach Anspruch 7, bei welcher das Entriegelungssignal geliefert wird, bevor die elektrischen Anschlüsse der ersten und zweiten Verbindungseinheiten getrennt werden.

9. Anordnung nach Anspruch 2, bei welcher die erste Verbindungseinheit (30) entsprechende Ausnehmungen (49, 50) auf seinen entgegengesetzten Seiten aufweist und die zweite Verbindungseinheit (60) ein Paar von rotierbaren Teilen (65) aufweist, welche entsprechende Haken (76) haben, die mit entsprechenden Ausnehmungen (49, 50) der ersten Verbindungseinheit (30), durch die Einführbewegung der ersten Verbindungseinheit (30) in die zweite Verbindungseinheit (60), zum Eingriff kommen.

10. Vorrichtung nach einem der vorhergehenden Ansprüche, bei welcher die erste Verbindungseinheit (30) eine als Kassette ausgebildete magnetische Blasenspeichereinheit und die zweite Verbindungseinheit (60) eine Halteeinrichtung zur Aufnahme der Speichereinheit ist.

11. Erste Verbindungseinheit zur Anordnung nach einem der vorhergehenden Ansprüche.

12. Zweite Verbindungseinheit zur Anordnung nach einem der vorhergehenden Ansprüche.

FIG. 1.

20 ←   ⇒ 10

FIG. 2.

FIG. 3.

1

FIG. 4.

_30_

34

_31_

_33_

_39_

40

_31a_

_39_

38

_32_

50

FIG. 5.

47

49

_30_

48  50

2

FIG. 6

FIG. 7

FIG. 8

# 0 057 329

## FIG. 9 (A)

## FIG. 9 (B)

## FIG. 9 (C)

5

FIG. 10

FIG. 11 (A)

FIG. 11 (B)

FIG. 12 ( A )

FIG. 12 (B)

FIG. 13

FIG. 14

FIG. 15

9

FIG. 16

FIG. 17

## FIG. 18 (A)

## FIG. 18 (B)